# EUROPEAN PATENT SPECIFICATION

(11) **EP 2 707 889 B1**
(45) Date of publication and mention of the grant of the patent: **18.09.2019**
(21) Application number: 12718686.4
(22) Date of filing: 08.05.2012
(51) Int. Cl.: H01H 11/00, H01H 9/56

(54) **AUTOMATIC ACQUISITION OF CIRCUIT BREAKER OPERATING TIMES FOR CONTROLLED SWITCHING**
AUTOMATISCHE ERFASSUNG VON LEISTUNGSSCHALTER SCHALTZEITEN FÜR GESTEUERTE SCHALTUNG
ACQUISITION AUTOMATIQUE DES TEMPS DE COMMUTATION DU DISJONCTEUR POUR COMMUTATION CONTRÔLÉE

(30) Priority: 09.05.2011 EP 11165290
(43) Date of publication of application: 19.03.2014
(73) Proprietor: ABB Schweiz AG, 5400 Baden (CH)
(72) Inventor: STANEK, Michael, 5412 Gebenstorf (CH)
(74) Representative: Vossius & Partner Patentanwälte Rechtsanwälte mbB
(86) International application number: PCT/EP2012/058458
(87) International publication number: WO 2012/152793

(56) References cited:
- EP-A1- 1 928 007
- EP-A1- 2 299 459
- EP-A2- 1 557 683
- DE-A1-102008 048 828
- DE-C1- 10 051 161
- FR-A1- 2 792 766
- US-A- 5 638 296
- US-A1- 2007 253 124

## Description

### Technical Field

The present invention relates to a method and device for acquiring circuit breaker properties by means of a point-on-wave controller, particularly in high-voltage AC power transmission networks.

### Introduction and Background Art

In many applications, switching transients can be reduced significantly by closing and opening circuit breakers (CBs) under point-on-wave (POW) control (also called "synchronous switching" or "controlled switching"). In short, it is to delay the CB operation in such a way that contact touch/separation and/or start/stop of current flow will occur at a point in time that is well suited for the CB, the switched load, and/or the network. This point in time is usually chosen as a specific phase angle of a reference voltage/current in the network that is monitored by a parameter interface of a POW controller. E.g., for capacitive loads, a well suited energization instant is usually at voltage zero.

For good synchronous switching performance, the POW controller needs to know the individual (mechanical) properties of the controlled CB device (for each CB pole for three-phase CBs), in particular the opening and closing times. Conventionally, these times are measured once during factory testing or on-site commissioning of the CB device with specialized equipment. The measured times are then programmed into the POW controller and are used for further operation.

However, the described procedure has the disadvantage of a tedious commissioning process.

Document EP-A-1557683 discloses a method and apparatus for acquiring the opening and/or closing times of high voltage circuit breakers.

FR 2 792 766 discloses a device for monitoring AC-voltages and AC-currents in a low voltage electrical circuit. Acquisition of closing or opening times is done online during live operation.

DE 100 51 161 discloses a method for reducing contact erosion in a three pole relay or contactor in a low-voltage AC electrical circuit. A contact burn-off is monitored online during each switching-off operation by measuring a time interval between deenergizing the relay coil and contact separation.

US 5 638 296 discloses a point-on-wave controller for network-synchronous operation of a switch in a high-voltage electrical network. Switching times of the switch are assumed to be constant or can be determined online by detecting the time when current starts flowing in the switched circuit.

EP 1 928 007 A1 discloses a method and apparatus for fault-current synchronous switching.

### Disclosure of the Invention

Hence it is a general objective of the present invention to provide methods and a device to at least partly overcome such disadvantages.

The objective is achieved by the methods and the device of the independent claims.

Accordingly, a method for acquiring a mechanical opening time and/or a mechanical closing time of a circuit breaker device by means of a point-on-wave controller, wherein the point-on-wave controller is permanently connected to a drive of the circuit breaker device, is provided. The method comprises the steps of temporarily connecting the primary contacts of the CB device (i.e. the contacts that are used for switching of, e.g., high-voltages during live operation) with dedicated measurement inputs, in particular dedicated binary measurement inputs, of the POW controller. In particular, these measurement inputs, in particular binary measurement inputs, are adapted for acquiring an (advantageously high-precision, i.e. ±0.1 ms) timing information for a mechanical switching operation of the CB device, and they are dedicated inputs of the POW controller. The term "dedicated" means here, that specifically not the (analog or digital) inputs of the parameter input interface of the POW controller are used. In particular, the term "dedicated", i.e. "specific", means that the measurement inputs, in particular binary measurement inputs, are only used for acquiring the timing information, in particular of the circuit breaker operation speed. For acquiring the timing information, a mechanical switching operation (opening and/or closing the primary contacts) is executed on the CB device, triggered or initiated by the POW controller itself. The time that is required for this mechanical switching operation is measured by the POW controller. Then the demanded property is derived from this measured time. Depending on the specific implementation, the POW controller might, e.g., be brought into a special operating mode for deriving the property (this can, e.g., be necessary if the measurement inputs are also used during live operation mode for a different purpose). Advantageously, the mechanical switching operation is executed several times and an averaged timing information and/or averaged derived property are obtained. The disclosed method has the advantage over prior art that no specialized equipment needs to be employed during commissioning, but the POW controller measures the demanded property of the CB device on its own. This simplifies the commissioning process.

The method additionally comprises the step of removing the temporary electrical connection after having derived the desired property.

The point-on-wave controller is permanently connected to a drive of the circuit breaker device.

The measuring of the time required for the mechanical switching operation of the circuit breaker device is done with the circuit breaker device not being connected to high voltage.

In an embodiment, the success of the mechanical switching operation, the time measurement, and/or the derivation of the property is assessed manually or automatically, e.g. from the acquired signals. This has the advantage that a failed attempt can be repeated and does not lead to the derivation of a wrong property which would deteriorate synchronous switching performance in live operation.

The mechanical opening time and/or mechanical closing time is then stored in a memory of the POW controller so that it can be used for later live operation. This has the advantage over prior art that a tedious (manual) transfer of the property from a measurement device to the POW controller becomes unnecessary. Advantageously, the individual measured switching times are also stored in the memory of the POW controller so that they can be used for later reference, e.g. in a commissioning protocol or for statistical analysis of the properties of each CB pole.

In another embodiment, not only the time required for a mechanical switching operation of a CB device is measured by the POW controller, but also one or more extra parameters that can influence the derived property, e.g., the opening or closing time of the CB device. Such extra parameters can include, e.g.:
- the ambient temperature (i.e., the temperature in the surrounding environment of the CB device),
- the drive temperature (i.e. the temperature(s) of the drive component(s) in the CB device),
- the control voltage (i.e. the voltage that is applied to the drive that actuates the interrupter of the CB device),
- the idle time since the last mechanical switching operation (i.e. the time that has passed since the last mechanical switching operation that has been executed on the CB device),
- the energy charge level of the CB device (i.e. the level of the energy buffer in the drive of the CB device). (Note: A typical CB device buffers the energy that is needed for driving its mechanical components, e.g. as electrical charge in a capacitor, as mechanical tension in a spring, or as a pressurized gas volume. After a mechanical switching operation this energy buffer needs to be recharged/refilled.),
- the closing time or opening time of a position sensor, in particular a binary position sensor such as an auxiliary contact (i.e. the time from triggering the CB operation until status change of a device that indicates at its output whether or not the CB device is in a specific position),
- the density or pressure of the insulating medium in the CB device, and/or
- the level of the insulating medium (i.e. how much insulating medium is present during the mechanical switching operation).

In another embodiment, these parameters are stored with the derived property, so that an allocation of the values of the derived property to the measured extra conditions is possible. As an example, the closing time of the CB device could be measured or derived at a drive temperature of -10 °C (for winter operation) and at +30 °C (for summer operation) ambient temperature. Then, if the CB device is operated, e.g. in spring at an ambient temperature of +15 °C, the corresponding closing time can advantageously be interpolated from the already derived data points of the property (here: CB closing time) as a function of the measured extra parameter. Thus, the performance of synchronous switching operations can be improved due to a better knowledge about the derived property.

If, in the above example, a certain dependency of the time difference from status change of main contact to status change of a particular binary position sensor has been determined, then in regular (live) operation the same dependency can be used to derive the time of primary contact status change from the time of binary position sensor status change. This may be advantageous for optimizing accuracy of POW switching operations.

In another embodiment, the method is applied to each pole of a three-phase circuit breaker device.

Furthermore, a point-on-wave controller is provided that is adapted to carry out one of the methods described above.

Furthermore, the use of a point-on-wave controller as described above in a power transmission network is provided.

In general, the current invention can be implemented as a device and/or a method.

### Brief Description of the Drawings

The invention will be better understood and objectives other than those set forth above will become apparent when consideration is given to the following detailed description of the invention. This description makes reference to the annexed drawings, wherein:
Fig. 1 schematically shows a setup for acquiring a CB property by means of a point-on-wave controller,
Fig. 2 schematically shows a possible working principle of a POW controller and a method for obtaining a property of a CB.

### Modes for Carrying Out the Invention

### Summary:

For good synchronous switching performance, a point-on-wave controller needs to know the (mechanical) properties of the controlled circuit breaker device, in particular the closing and opening times. Here, a method and a device for the acquisition of a plurality of properties of circuit breaker devices by means of a point-on-wave controller and a method for operating such a point-on-wave controller are disclosed. A point-on-wave controller according to the invention determines properties of a connected circuit breaker device during testing and/or commissioning. For this, the CB's primary contacts are temporarily connected to the point-on-wave controller and mechanical switching operations are performed. The point-on-wave controller then measures the times required for switching operations, and optionally also extra parameters like drive temperature, and derives the demanded properties from these measurements. From them, it calculates improved operation strategies for the CB during live operation.

### Definitions:

The term "high-voltage" relates to voltages larger than 1 kV, in particular larger than 72 kV.

### Description of the Figures:

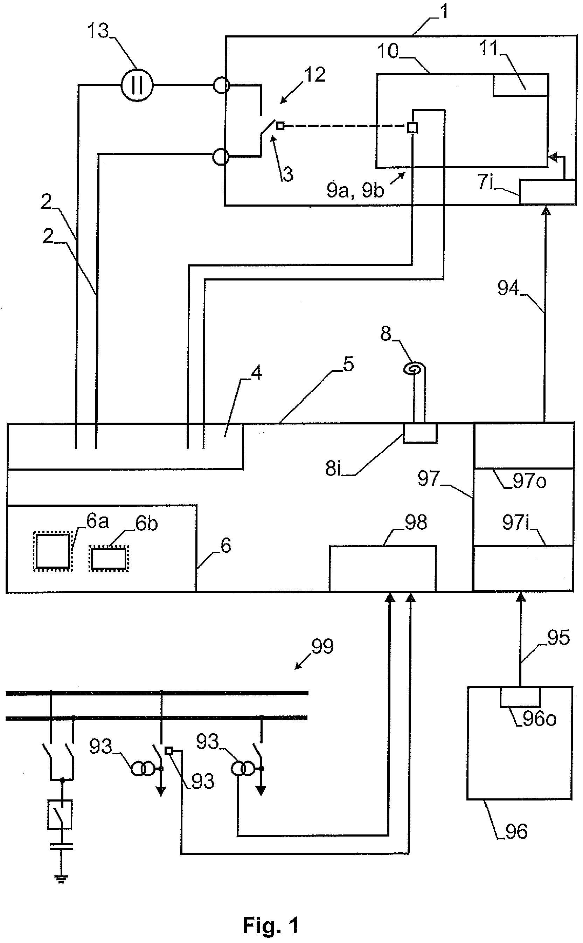

Figure 1 schematically shows a setup for acquiring a CB property (e.g. an opening time t_{O} and/or a closing time t_{C}) by means of a point-on-wave controller 5. The interrupter comprising the primary contacts 3 of the CB device 1 is driven by a drive 10 of the CB device 1 and insulated with an insulation medium 12 such as SF₆ to reduce arcing and improve insulation at high-voltages. The CB device 1 furthermore comprises an energy buffer 11 (e.g. a capacitor for electrical drives 10, a spring for mechanical drives 10, or a volume of compressed gas for pneumatically operated drives 10) to enable swift switching actions. The energy charge level in the energy buffer 11 influences the opening and/or closing time of the CB device 1, and the energy buffer 11 needs to be refilled after each switching action. The CB device 1 furthermore comprises a control input 7i (which is normally a part of the drive 10) which receives a circuit breaker actuation command 94 (e.g., an opening/closing command) from the POW controller 5, specifically from its command output 97o of its command interface 97. Optional binary position sensors 9a, 9b such as auxiliary contacts can be arranged on the CB device 1 to monitor opening and/or closing of the interrupter of the CB device 1.

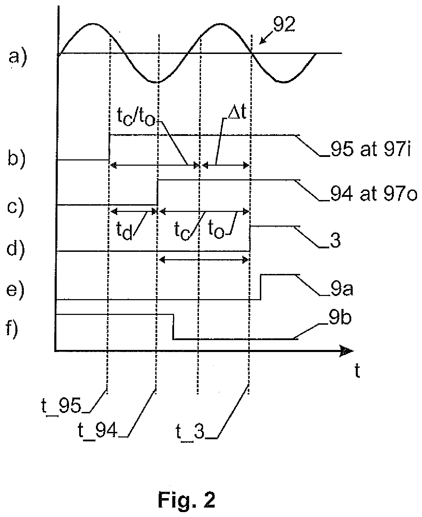

The POW controller 5 comprises a control unit 6 which itself comprises a CPU 6a and a memory 6b which can be (in part) non-volatile. This control unit 6 controls the operation of the POW controller 5 (as schematically shown in Fig. 2) and introduces a delay t_{d} between an external switching command 95 (at time t 95) and the issued circuit breaker actuation command 94 (at time t 94). The external switching command 95 usually originates from a command output 96o of a command issuing device 96, such as, e.g., a bay controller, and it is received by a command input 97i of the POW controller's command interface 97. The introduced delay t_{d} enables synchronous switching of the CB device 1, e.g. at a zero crossing 92 of a monitored operating parameter of a power transmission network 99, such as a voltage. The delay t_{d} is on the one hand dependent on a plurality of said operating parameters of the power transmission network 99 (e.g. voltages, binary switch states etc. that are acquired with monitoring devices 93 in the network). These operating parameters are monitored by the POW controller 5 via its parameter input interface 98. On the other hand, said delay t_{d} is dependent on the properties of the CB device 1 (e.g. the opening time t_{O} and/or the closing time t_{C} of the primary contacts 3 of the interrupter), if a good synchronous switching performance is desired. Therefore, the property t_{O} and/or t_{C} is derived by the POW controller 5 in a pre-live-operation commissioning and/or testing cycle.

For this, as a first step, a temporary electrical connection 2 is established between the primary contacts 3 (i.e. the main contacts that are used for high-voltage switching in live operation) of the CB device 1 and dedicated measurement inputs 4, e.g. dedicated binary measurement inputs 4, of the POW controller 5. Here, "binary dedicated" can mean that a threshold measurement or threshold monitoring is performed on an analog output or analog signal. A voltage source 13 can be arranged separately in the circuit to enable facilitated readout of the desired information, or it may be part of the measurement interface 4. To obtain precise timing information, the measurement inputs 4 of the POW controller 5 are adapted for acquiring a (preferably high-precision, e.g. with a precision of ±0.1 ms) timing information for a mechanical switching operation of the main contacts 3 of the CB device 1. As a next step, such a mechanical switching operation for the CB device 1 is triggered, advantageously by the POW controller 5 itself, and the time required for this mechanical switching operation of said CB device 1 is measured by the POW controller 5, specifically by said measurement inputs 4. Then, the desired property (here: t_{C} and/or t_{O}) of the CB device 1 is derived by the control unit 4 of the POW controller 5 and advantageously stored in its non-volatile memory 6b for future live operation.

After having derived the desired property, the temporary electrical connection 2 is removed such that the CB device 1 can be used for high-voltage switching.

As discussed above, extra parameters might influence the derived property (e.g. the opening t_{O} and/or closing time t_{C}) of the CB device 1. An extension of the above method is therefore to measure and store not only the property of the CB device 1 itself, but also said extra parameter(s) which is or are measured by a sensor 8 connected to the POW controller via an interface 8i. This extra parameter could include, e.g., ambient and/or drive temperatures, control voltage of the drive 10, idle time of the CB device 1, energy charge level of the energy buffer 11, timing information of binary position sensors 9a, 9b, and/or density/pressure/level of the insulating medium 12. When combining all information, the dependency of the derived property of the CB device 1, e.g. the opening/closing time t_{O} and/or t_{C}, can be derived as a function of the measured extra parameter(s). This knowledge - advantageously including interpolation and/or extrapolation steps - can then be used for compensation to optimize synchronous switching performance in live operation with changing extra parameters.

Fig. 2 schematically shows a possible working principle of a POW controller and a method for obtaining a property of a CB, e.g. an opening and/or closing time t_{O} and/or t_{C}. As discussed above, the POW controller 5 monitors a plurality of operating parameters of a power transmission network 99. Such an operating parameter could, e.g., be a sinusoidal voltage as drawn in Fig. 2a). Now, when a CB device 1 is to be actuated, a command issuing device 96, e.g. a bay controller, issues an arbitrarily timed external switching command 95 to the POW controller 5. If the external switching command 95 were executed instantaneously by the CB device 1, the interrupter would open/close after a time t_{O} and/or t_{C} (i.e. unsynchronized to said operating parameter by a time deviation Δt), as it is shown in Fig. 2b). For network synchronized switching, the POW controller 5 therefore delays the execution of the switching by a time t_{d}=Δt after which it issues the circuit breaker actuation command 94, as it is shown in Fig. 2c). Then, after the opening/closing time t_{O} and/or t_{C} the interrupter opens/closes the primary contacts 3 synchronized to the operating parameter (at time t_3), as it is shown in Fig. 2d). Optional binary position sensors 9a, 9b, e.g. auxiliary contacts, can be arranged on the CB device 1 to report the opening/closing of the interrupter as shown in Figs. 2e) and 2f).

### Notes:

While there are shown and described presently preferred (i.e. exemplary) embodiments of the invention, it is to be distinctly understood that the invention is not limited to these embodiments, but may be otherwise embodied and practiced within the scope of the claims.

### Reference numbers

- tₒ:: opening time
- t_{c}:: closing time
- Δt:: time deviation
- t_{d}:: time delay
- 1:: circuit breaker device
- 2:: temporary electrical connection
- 3:: primary contacts
- 4:: measurement inputs
- 5:: point-on-wave controller
- 6:: control unit
- 6a:: central processing unit (CPU)
- 6b:: memory
- 7i:: control input
- 8:: sensor
- 8i:: sensor interface
- 9a, 9b:: binary position sensors
- 10:: drive
- 11:: energy buffer
- 12:: insulating medium
- 13:: voltage source
- 92:: zero crossing
- 93:: monitoring device
- 94:: circuit breaker actuation command
- 95:: external switching command
- 96:: command issuing device
- 96o:: command output (of command issuing device 96)
- 97:: command interface (of POW controller 5)
- 97i:: command input (of command interface 97)
- 97o:: command output (of command interface 97)
- 98:: parameter interface
- 99:: power transmission network

## Claims

1. A method for acquiring an opening time and/or a closing time of a circuit breaker device (1) in a high-voltage AC power transmission network (99), wherein
a point-on-wave controller (5) is assigned to the circuit breaker device (1),
the point-on-wave controller (5) is permanently connected to a drive of the circuit breaker device (1), and
the point-on-wave controller (5) has dedicated measurement inputs (4), that are adapted for acquiring a timing information for a mechanical switching operation of the circuit breaker device (1),
the method comprising:
establishing a temporary electrical connection (2) between primary contacts (3), which primary contacts (3) are used for high-voltage switching during live operation, of said circuit breaker device (1) and the dedicated measurement inputs (4),
a mechanical switching operation of said circuit breaker device (1) is initiated by said point-on-wave controller (5),
measuring, by means of said point-on-wave controller (5), a time required for the mechanical switching operation of said circuit breaker device (1), wherein the measuring of the time required for the mechanical switching operation of the circuit breaker device (1) is done with the circuit breaker device (1) not being connected to high voltage,
deriving, by means of said point-on-wave controller (5), the opening time and/or closing time based on said measured time,
calculating, by means of said point-on-wave controller (5), improved operation strategies for the circuit breaker device (1) during the live operation, and
removing the temporary electrical connection (2) after having derived the opening time and/or closing time, such that the circuit breaker device (1) is used for the high-voltage switching, and
additionally comprising a step of storing the derived opening time and/or closing time in a memory (6b) of said point-on-wave controller (5) for being used for later live operation.

2. The method of the preceding claim, additionally comprising the step of assessing a success of said mechanical switching operation and/or said measuring of said time and/or said deriving of the opening time and/or closing time.

3. The method of any of the preceding claims, additionally comprising the step of storing the measured time in the memory (6b) of said point-on-wave controller (5) for being used for later live operation.

4. The method of any of the preceding claims, wherein to obtain precise timing information, the measurement inputs (4) of the point-on-wave controller (5) are adapted for acquiring a high-precision timing information with a precision of ±0.1 ms for a mechanical switching operation of the main contacts (3) of the circuit breaker device (1),
and such a mechanical switching operation for the circuit breaker device (1) is triggered by the point-on-wave controller (5) itself and the time required for this mechanical switching operation of said circuit breaker device (1) is measured by the point-on-wave controller (5) by said measurement inputs (4).

5. The method of any of the preceding claims, additionally comprising the step of measuring, by means of said point-on-wave controller (5), at least one extra parameter of said mechanical switching operation.

6. The method of claim 5, wherein said extra parameter comprises at least one of the group of an ambient temperature, a drive temperature of said circuit breaker device (1), a control voltage of said circuit breaker device (1), an idle time of said circuit breaker device (1) since a last mechanical switching operation, an energy charge level of said circuit breaker device (1), a closing and/or opening time of a position sensor (9a, 9b) of said circuit breaker device (1), a density of an insulating medium in said circuit breaker device (1), a pressure of said insulating medium in said circuit breaker device (1), and a level of said insulating medium in said circuit breaker device (1).

7. The method of any of the claims 5-6, wherein said extra parameter is stored with said opening time and/or closing time and/or is used for deriving said opening time and/or closing time by said point-on-wave controller (5).

8. The method of any of the claims 5-7, further comprising the step of carrying out at least one of the group of an interpolation operation and an extrapolation operation of said property as a function of said extra parameter.

9. The method of any of the preceding claims, wherein said deriving of said opening time and/or closing time comprises an averaging operation over more than one mechanical switching operation.

10. The method of any of the preceding claims, wherein said opening time and/or closing time is an opening time (t_{O}) and/or a closing time (t_{C}) of an interrupter of said circuit breaker device (1).

11. The method of any of the preceding claims, wherein said dedicated measurement inputs (4) are binary dedicated measurement inputs (4).

12. The method of any of the preceding claims, wherein the method is applied to each pole of a three-phase circuit breaker device (1).

13. A point-on-wave controller (5) used in a high-voltage AC power transmission network (99), wherein said point-on-wave controller (5) is adapted to carry out the method for acquiring an opening time and/or a closing time of a circuit breaker device (1) in a high-voltage AC power transmission network (99) of any of the preceding claims 1-12, wherein
the point-on-wave controller (5) is assigned to the circuit breaker device (1),
the point-on-wave controller (5) is configured to be permanently connected to a drive of the circuit breaker device (1), and
the point-on-wave controller (5) has dedicated measurement inputs (4), that are adapted for acquiring a timing information for a mechanical switching operation of the circuit breaker device (1) and that are adapted to be temporarily connectable to said primary contacts (3) of said circuit breaker device (1),
the method comprising:
establishing a temporary electrical connection (2) between primary contacts (3), which primary contacts (3) are used for high-voltage switching during live operation, of said circuit breaker device (1) and the dedicated measurement inputs (4),
wherein said point-on-wave controller (5) is configured to initiate a mechanical switching operation of said circuit breaker device (1), to measure a time required for the mechanical switching operation of said circuit breaker device (1) wherein the measuring of the time required for the mechanical switching operation of the circuit breaker device (1) is done with the circuit breaker device (1) not being connected to high voltage, to derive the opening time and/or closing time based on said measured time and to calculate improved operation strategies for the circuit breaker device (1) during the live operation,
removing the temporary electrical connection (2) after having derived the opening time and/or closing time, such that the circuit breaker device (1) is used for the high-voltage switching, and
additionally comprising a step of storing the derived opening time and/or closing time in a memory (6b) of said point-on-wave controller (5) for being used for later live operation.

14. The point-on-wave controller (5) of claim 13, further comprising a command interface (97), a parameter interface (98), and a control unit (6) wherein
said command interface (97) comprises a command input (97i) which is adapted to be connectable to a command output (96o) of a command issuing device (96) and to receive an external switching command (95),
said command interface (97) furthermore comprises a command output (97o) which is adapted to be connectable to a control input (7i) of said circuit breaker device (1) and to issue a circuit breaker actuation command (94),
said parameter interface (98) is adapted to be connectable to a plurality of monitoring devices (93) and to measure operating parameters from said power transmission network (99),
said control unit (6) comprises a central processing unit (6a) and a memory (6b) and is adapted to delay said external switching command (95) from said command interface (97) based on said operating parameters and to issue said circuit breaker actuation command (94) via said command interface (97), wherein
said point-on-wave controller (5) furthermore comprises dedicated measurement inputs (4) that are adapted to be temporarily connectable to said primary contacts (3) of said circuit breaker device (1),
said control unit (6) is adapted for measuring said time and for deriving said opening time and/or closing time based on said measured time, and
said control unit (6) is furthermore adapted to delay said external switching command (95) based on said opening time and/or closing time of said circuit breaker device (1).

15. The point-on-wave controller (5) of any of the claims 13-14, wherein
said point-on-wave controller (5) comprises at least one interface (8i) to at least one sensor (8) which is adapted for measuring said extra parameter.

16. Use of a point-on-wave controller (5) of any of the claims 13-15 in a power transmission network (99) .

## Patentansprüche

1. Ein Verfahren zum Erfassen einer Öffnungszeit und/oder Schließzeit einer Stromkreisunterbrechungsvorrichtung (1) in einem Hochspannungs-Wechselstromübertragungsnetz (99), wobei
ein Synchron-Steuergerät (5) der Stromkreisunterbrechungsvorrichtung (1) zugeordnet ist, das Synchron-Steuergerät (5) permanent mit einem Antrieb der Stromkreisunterbrechungsvorrichtung (1) verbunden ist, und
das Synchron-Steuergerät (5) dedizierte Messeingänge (4) aufweist, die zum Erfassen einer Zeitinformation für einen mechanischen Schaltvorgang der Stromkreisunterbrechungsvorrichtung (1) angepasst sind, wobei das Verfahren umfasst:
Herstellen einer temporären elektrischen Verbindung (2) zwischen Primärkontakten (3) der Stromkreisunterbrechungsvorrichtung (1) und den dedizierten Messeingängen (4), wobei die Primärkontakte (3) zum Schalten von Hochspannungen im laufenden Betrieb verwendet werden,
ein mechanischer Schaltvorgang der Stromkreisunterbrechungsvorrichtung (1) durch das Synchron-Steuergerät (5) eingeleitet wird,
Messen einer Zeit, die für den mechanischen Schaltvorgang der Stromkreisunterbrechungsvorrichtung (1) erforderlich ist, mittels des Synchron-Steuergeräts (5), wobei das Messen der Zeit, die für den mechanischen Schaltvorgang der Stromkreisunterbrechungsvorrichtung (1) erforderlich ist, erfolgt, wenn die Stromkreisunterbrechungsvorrichtung (1) nicht an Hochspannung angeschlossen ist,
Ableiten der Öffnungszeit und/oder Schließzeit mittels des Synchron-Steuergeräts (5) basierend auf der gemessenen Zeit,
Berechnen verbesserter Betriebsstrategien für die Stromkreisunterbrechungsvorrichtung (1) während des laufenden Betriebs mittels des Synchron-Steuergeräts (5), und
Entfernen der temporären elektrischen Verbindung (2) nach dem Ableiten der Öffnungszeit und/oder Schließzeit, so dass die Stromkreisunterbrechungsvorrichtung (1) für das Hochspannungs-Schalten verwendet wird, und
zusätzlich umfassend einen Schritt zum Speichern der abgeleiteten Öffnungszeit und/oder Schließzeit in einem Speicher (6b) des Synchron-Steuergeräts (5) zur Verwendung für den späteren laufenden Betrieb.

2. Das Verfahren nach dem vorhergehenden Anspruch, zusätzlich umfassend den Schritt des Bewertens eines Erfolgs des mechanischen Schaltvorgangs und/oder des Messens der Zeit und/oder des Ableitens der Öffnungszeit und/oder Schließzeit.

3. Das Verfahren nach einem der vorhergehenden Ansprüche, zusätzlich umfassend den Schritt des Speicherns der gemessenen Zeit im Speicher (6b) des Synchron-Steuergeräts (5) zur Verwendung für einen späteren laufenden Betrieb.

4. Das Verfahren nach einem der vorhergehenden Ansprüche, wobei zum Erhalten einer genauen Zeitinformation die Messeingänge (4) des Synchron-Steuergeräts (5) zum Erfassen einer hochpräzisen Zeitinformation mit einer Genauigkeit von ±0,1 ms für einen mechanischen Schaltvorgang der Hauptkontakte (3) der Stromkreisunterbrechungsvorrichtung (1) angepasst sind,
und ein solcher mechanischer Schaltvorgang für die Stromkreisunterbrechungsvorrichtung (1) durch das Synchron-Steuergerät (5) selbst ausgelöst wird, und die für diesen mechanischen Schaltvorgang der Stromkreisunterbrechungsvorrichtung (1) erforderliche Zeit durch das Synchron-Steuergerät (5) durch die Messeingänge (4) gemessen wird.

5. Das Verfahren nach einem der vorhergehenden Ansprüche, zusätzlich umfassend den Schritt des Messens mindestens eines zusätzlichen Parameters des mechanischen Schaltvorgangs mittels des Synchron-Steuergeräts (5).

6. Das Verfahren nach Anspruch 5, wobei der zusätzliche Parameter mindestens einen aus der Gruppe einer Umgebungstemperatur, einer Antriebstemperatur der Stromkreisunterbrechungsvorrichtung (1), einer Steuerspannung der Stromkreisunterbrechungsvorrichtung (1), einer Leerlaufzeit der Stromkreisunterbrechungsvorrichtung (1) seit einem letzten mechanischen Schaltvorgang, einen Energieladezustand der Stromkreisunterbrechungsvorrichtung (1), eine Schließ- und/oder Öffnungszeit eines Positionssensors (9a, 9b) der Stromkreisunterbrechungsvorrichtung (1), eine Dichte eines Isoliermediums in der Stromkreisunterbrechungsvorrichtung (1), einen Druck des Isoliermediums in der Stromkreisunterbrechungsvorrichtung (1) und einen Grad des Isoliermediums in der Stromkreisunterbrechungsvorrichtung (1) umfasst.

7. Das Verfahren nach einem der Ansprüche 5-6, wobei der zusätzliche Parameter mit der Öffnungszeit und/oder Schließzeit gespeichert wird und/oder zum Ableiten der Öffnungszeit und/oder Schließzeit durch das Synchron-Steuergerät (5) verwendet wird.

8. Das Verfahren nach einem der Ansprüche 5-7, ferner umfassend den Schritt des Durchführens von mindestens einem aus der Gruppe einer Interpolationsoperation und einer Extrapolationsoperation der Eigenschaft als Funktion des zusätzlichen Parameters.

9. Das Verfahren nach einem der vorhergehenden Ansprüche, wobei das Ableiten der Öffnungszeit und/oder Schließzeit einen Mittelungsvorgang über mehr als einen mechanischen Schaltvorgang umfasst.

10. Das Verfahren nach einem der vorhergehenden Ansprüche, wobei die Öffnungszeit und/oder Schließzeit eine Öffnungszeit (t_{O}) und/oder eine Schließzeit (t_{C}) eines Unterbrechers der Stromkreisunterbrechungsvorrichtung (1) ist.

11. Das Verfahren nach einem der vorhergehenden Ansprüche, wobei die dedizierten Messeingänge (4) binäre dedizierte Messeingänge (4) sind.

12. Das Verfahren nach einem der vorhergehenden Ansprüche, wobei das Verfahren auf jeden Pol einer Dreiphasen-Stromkreisunterbrechungsvorrichtung (1) angewendet wird.

13. Ein Synchron-Steuergerät (5), die in einem Hochspannungs-Wechselstromübertragungsnetz (99) verwendet wird, wobei das Synchron-Steuergerät (5) zum Durchführen des Verfahrens zum Erfassen einer Öffnungszeit und/oder einer Schließzeit einer Stromkreisunterbrechungsvorrichtung (1) in einem Hochspannungs-Wechselstromübertragungsnetz (99) nach einem der vorhergehenden Ansprüche 1-12 angepasst ist, wobei
das Synchron-Steuergerät (5) der Stromkreisunterbrechungsvorrichtung (1) zugeordnet ist, das Synchron-Steuergerät (5) zum permanenten Verbinden mit einem Antrieb der Stromkreisunterbrechungsvorrichtung (1) ausgelegt ist, und
das Synchron-Steuergerät (5) dedizierte Messeingänge (4) aufweist, die zum Erfassen einer Zeitinformation für einen mechanischen Schaltvorgang der Stromkreisunterbrechungsvorrichtung (1) angepasst sind und die dazu angepasst sind, temporär mit den Primärkontakten (3) der Stromkreisunterbrechungsvorrichtung (1) verbindbar zu sein,
wobei das Verfahren umfasst:
Herstellen einer temporären elektrischen Verbindung (2) zwischen Primärkontakten (3) der Stromkreisunterbrechungsvorrichtung (1) und den dedizierten Messeingängen (4), wobei die Primärkontakte (3) zum Schalten von Hochspannungen im laufenden Betrieb verwendet werden,
wobei das Synchron-Steuergerät (5) zum Einleiten eines mechanischen Schaltvorgangs der Stromkreisunterbrechungsvorrichtung (1) ausgelegt ist, um eine für den mechanischen Schaltvorgang der Stromkreisunterbrechungsvorrichtung (1) erforderliche Zeit zu messen, wobei das Messen der für den mechanischen Schaltvorgang der Stromkreisunterbrechungsvorrichtung (1) erforderlichen Zeit durchgeführt wird, wenn die Stromkreisunterbrechungsvorrichtung (1) nicht an Hochspannung angeschlossen ist, um die Öffnungszeit und/oder Schließzeit basierend auf der gemessenen Zeit abzuleiten und verbesserte Betriebsstrategien für die Stromkreisunterbrechungsvorrichtung (1) während des laufenden Betriebs zu berechnen,
Entfernen der temporären elektrischen Verbindung (2) nach dem Ableiten der Öffnungszeit und/oder Schließzeit, so dass die Stromkreisunterbrechungsvorrichtung (1) für das Hochspannungs-Schalten verwendet wird, und
zusätzlich umfassend einen Schritt zum Speichern der abgeleiteten Öffnungszeit und/oder Schließzeit in einem Speicher (6b) des Synchron-Steuergeräts (5) zur Verwendung für den späteren laufenden Betrieb.

14. Das Synchron-Steuergerät (5) nach Anspruch 13, ferner umfassend eine Befehlsschnittstelle (97), eine Parameterschnittstelle (98) und eine Steuereinheit (6), wobei
die Befehlsschnittstelle (97) einen Befehlseingang (97i) umfasst, der dazu angepasst ist, mit einem Befehlsausgang (96o) einer Befehlsausgabevorrichtung (96) verbindbar zu sein und einen externen Schaltbefehl (95) zu empfangen,
die Befehlsschnittstelle (97) ferner einen Befehlsausgang (97o) umfasst, der dazu angepasst ist, mit einem Steuereingang (7i) der Stromkreisunterbrechungsvorrichtung (1) verbindbar zu sein und einen Stromkreisunterbrechungsbetätigungsbefehl (94) auszugeben,
die Parameterschnittstelle (98) dazu angepasst ist, mit mehreren Überwachungsvorrichtungen (93) verbindbar zu sein und Betriebsparameter von dem Leistungsübertragungsnetz (99) zu messen,
die Steuereinheit (6) eine zentrale Verarbeitungseinheit (6a) und einen Speicher (6b) umfasst und dazu angepasst ist, den externen Schaltbefehl (95) von der Befehlsschnittstelle (97) basierend auf den Betriebsparametern zu verzögern und den Stromkreisunterbrechungsbetätigungsbefehl (94) über die Befehlsschnittstelle (97) auszugeben, wobei das Synchron-Steuergerät (5) ferner dedizierte Messeingänge (4) umfasst, die dazu angepasst sind, temporär mit den Primärkontakten (3) der Stromkreisunterbrechungsvorrichtung (1) verbindbar zu sein,
die Steuereinheit (6) zum Messen der Zeit und zum Ableiten der Öffnungszeit und/oder Schließzeit basierend auf der gemessenen Zeit angepasst ist, und die Steuereinheit (6) ferner dazu angepasst ist, den externen Schaltbefehl (95) basierend auf der Öffnungszeit und/oder Schließzeit der Stromkreisunterbrechungsvorrichtung (1) zu verzögern.

15. Das Synchron-Steuergerät (5) nach einem der Ansprüche 13-14, wobei
das Synchron-Steuergerät (5) mindestens eine Schnittstelle (8i) zu mindestens einem Sensor (8) umfasst, der zum Messen des zusätzlichen Parameters angepasst ist.

16. Verwenden eines Synchron-Steuergeräts (5) nach einem der Ansprüche 13-15 in einem Stromübertragungsnetz (99).

## Revendications

1. Un procédé pour acquérir un temps d'ouverture et/ou un temps de fermeture d'un dispositif disjoncteur (1) dans un réseau de transmission de puissance CA de haute tension (99), dans lequel
un contrôleur point sur onde (5) est affecté au dispositif disjoncteur (1),
le contrôleur point sur onde (5) est connecté en permanence à un excitateur du dispositif disjoncteur (1), et
le contrôleur point sur onde (5) a des entrées de mesure dédiées (4), qui sont conçues pour acquérir des informations de synchronisation pour une opération de commutation mécanique du dispositif disjoncteur (1),
le procédé comprenant :
l'établissement d'une connexion électrique temporaire (2) entre des contacts primaires (3), ces contacts primaires (3) étant utilisés pour une commutation en haute tension durant un fonctionnement sous tension, dudit dispositif disjoncteur (1) et les entrées de mesure dédiées (4),
une opération de commutation mécanique dudit dispositif disjoncteur (1) est amorcée par ledit contrôleur point sur onde (5),
la mesure, au moyen dudit contrôleur point sur onde (5), d'un temps requis pour l'opération de commutation mécanique dudit dispositif disjoncteur (1), la mesure du temps requis pour l'opération de commutation mécanique du dispositif disjoncteur (1) étant effectuée alors que le dispositif disjoncteur (1) n'est pas connecté à une haute tension,
la dérivation, au moyen dudit contrôleur point sur onde (5), du temps d'ouverture et/ou temps de fermeture sur la base dudit temps mesuré,
le calcul, au moyen dudit contrôleur point sur onde (5), de stratégies de fonctionnement améliorées pour le dispositif disjoncteur (1) durant le fonctionnement sous tension, et
l'enlèvement de la connexion électrique temporaire (2) après avoir dérivé le temps d'ouverture et/ou temps de fermeture, de telle sorte que le dispositif disjoncteur (1) soit utilisé pour la commutation en haute tension, et
comprenant additionnellement une étape de stockage du temps d'ouverture et/ou temps de fermeture dérivé dans une mémoire (6b) dudit contrôleur point sur onde (5) pour être utilisé pour un fonctionnement sous tension ultérieur.

2. Le procédé de la revendication précédente, comprenant additionnellement l'étape d'évaluation du succès de ladite opération de commutation mécanique et/ou de ladite mesure dudit temps et/ou de ladite dérivation du temps d'ouverture et/ou temps de fermeture.

3. Le procédé de l'une quelconque des revendications précédentes, comprenant additionnellement l'étape de stockage du temps mesuré dans la mémoire (6b) dudit contrôleur point sur onde (5) pour être utilisé pour un fonctionnement sous tension ultérieur.

4. Le procédé de l'une quelconque des revendications précédentes, dans lequel pour obtenir des informations de synchronisation précises, les entrées de mesure (4) du contrôleur point sur onde (5) sont conçues pour acquérir des informations de synchronisation de haute précision avec une précision de ±0,1 ms pour une opération de commutation mécanique des contacts principaux (3) du dispositif disjoncteur (1),
et une telle opération de commutation mécanique pour le dispositif disjoncteur (1) est déclenchée par le contrôleur point sur onde (5) lui-même et le temps requis pour cette opération de commutation mécanique dudit dispositif disjoncteur (1) est mesuré par le contrôleur point sur onde (5) grâce auxdites entrées de mesure (4).

5. Le procédé de l'une quelconque des revendications précédentes, comprenant additionnellement l'étape de mesure, au moyen dudit contrôleur point sur onde (5), d'au moins un paramètre supplémentaire de ladite opération de commutation mécanique.

6. Le procédé de la revendication 5, dans lequel ledit paramètre supplémentaire comprend au moins un élément du groupe comportant une température ambiante, une température d'excitation dudit dispositif disjoncteur (1), une tension de contrôle dudit dispositif disjoncteur (1), un temps de repos dudit dispositif disjoncteur (1) depuis une dernière opération de commutation mécanique, un niveau de charge d'énergie dudit dispositif disjoncteur (1), un temps de fermeture et/ou d'ouverture d'un capteur de position (9a, 9b) dudit dispositif disjoncteur (1), une densité d'un milieu isolant dans ledit dispositif disjoncteur (1), une pression dudit milieu isolant dans ledit dispositif disjoncteur (1), et un niveau dudit milieu isolant dans ledit dispositif disjoncteur (1).

7. Le procédé de l'une quelconque des revendications 5-6, dans lequel ledit paramètre supplémentaire est stocké avec ledit temps d'ouverture et/ou temps de fermeture et/ou est utilisé pour la dérivation dudit temps d'ouverture et/ou temps de fermeture par ledit contrôleur point sur onde (5).

8. Le procédé de l'une quelconque des revendications 5-7, comprenant en outre l'étape de réalisation d'au moins une opération du groupe comportant une opération d'interpolation et une opération d'extrapolation de ladite propriété comme une fonction dudit paramètre supplémentaire.

9. Le procédé de l'une quelconque des revendications précédentes, dans lequel la dérivation dudit temps d'ouverture et/ou temps de fermeture comprend une opération de calcul de la moyenne sur plus d'une opération de commutation mécanique.

10. Le procédé de l'une quelconque des revendications précédentes, dans lequel ledit temps d'ouverture et/ou temps de fermeture est un temps d'ouverture (tₒ) et/ un temps de fermeture (t_{c}) d'un interrupteur dudit dispositif disjoncteur (1).

11. Le procédé de l'une quelconque des revendications précédentes, dans lequel lesdites entrées de mesure dédiées (4) sont des entrées de mesure dédiées (4) binaires.

12. Le procédé de l'une quelconque des revendications précédentes, le procédé étant appliqué à chaque pôle d'un dispositif disjoncteur triphasé (1).

13. Un contrôleur point sur onde (5) utilisé dans un réseau de transmission de puissance CA de haute tension (99), ledit contrôleur point sur onde (5) étant conçu pour réaliser le procédé pour acquérir un temps d'ouverture et/ou un temps de fermeture d'un dispositif disjoncteur (1) dans un réseau de transmission de puissance CA de haute tension (99) de l'une quelconque des revendications précédentes 1-12,
le contrôleur point sur onde (5) étant affecté au dispositif disjoncteur (1),
le contrôleur point sur onde (5) étant configuré pour être connecté en permanence à un excitateur du dispositif disjoncteur (1), et
le contrôleur point sur onde (5) ayant des entrées de mesure dédiées (4), qui sont conçues pour acquérir des informations de synchronisation pour une opération de commutation mécanique du dispositif disjoncteur (1) et sont conçues pour être aptes à être connectées temporairement auxdits contacts primaires (3) dudit dispositif disjoncteur (1),
le procédé comprenant :
l'établissement d'une connexion électrique temporaire (2) entre des contacts primaires (3), ces contacts primaires (3) étant utilisés pour une commutation en haute tension durant un fonctionnement sous tension, dudit dispositif disjoncteur (1) et les entrées de mesure dédiées (4),
dans lequel ledit contrôleur point sur onde (5) est configuré pour amorcer une opération de commutation mécanique dudit dispositif disjoncteur (1), pour mesurer un temps requis pour l'opération de commutation mécanique dudit dispositif disjoncteur (1), la mesure du temps requis pour l'opération de commutation mécanique du dispositif disjoncteur (1) étant effectuée alors que le dispositif disjoncteur (1) n'est pas connecté à une haute tension, pour dériver le temps d'ouverture et/ou temps de fermeture sur la base dudit temps mesuré et pour calculer des stratégies de fonctionnement améliorées pour le dispositif disjoncteur (1) durant le fonctionnement sous tension,
l'enlèvement de la connexion électrique temporaire (2) après avoir dérivé le temps d'ouverture et/ou temps de fermeture, de telle sorte que le dispositif disjoncteur (1) soit utilisé pour la commutation en haute tension, et
comprenant additionnellement une étape de stockage du temps d'ouverture et/ou temps de fermeture dérivé dans une mémoire (6b) dudit contrôleur point sur onde (5) pour être utilisé pour un fonctionnement sous tension ultérieur.

14. Le contrôleur point sur onde (5) de la revendication 13, comprenant en outre une interface de commande (97), une interface de paramétrage (98), et une unité de contrôle (6) dans lequel
ladite interface de commande (97) comprend une entrée de commande (97i) qui est conçue pour être apte à être connectée à une sortie de commande (96o) d'un dispositif émetteur de commandes (96) et pour recevoir une commande de commutation externe (95),
ladite interface de commande (97) comprenant en outre une sortie de commande (97o) qui est conçue pour être apte à être connectée à une entrée de contrôle (7i) dudit dispositif disjoncteur (1) et pour émettre une commande d'actionnement de disjoncteur (94),
ladite interface de paramétrage (98) est conçue pour être apte à être connectée à une pluralité de dispositifs de surveillance (93) et pour mesurer des paramètres d'exploitation à partir dudit réseau de transmission de puissance (99),
ladite unité de contrôle (6) comprend une unité centrale de traitement (6a) et une mémoire (6b) et est conçue pour retarder ladite commande de commutation externe (95) en provenance de ladite interface de commande (97) sur la base desdits paramètres d'exploitation et pour émettre ladite commande d'actionnement de disjoncteur (94) via ladite interface de commande (97),
ledit contrôleur point sur onde (5) comprenant en outre des entrées de mesure dédiées (4) qui sont conçues pour être aptes à être connectées temporairement auxdits contacts primaires (3) dudit dispositif disjoncteur (1),
ladite unité de contrôle (6) étant conçue pour mesurer ledit temps et pour dériver ledit temps d'ouverture et/ou temps de fermeture sur la base dudit temps mesuré, et
ladite unité de contrôle (6) est conçue en outre pour retarder ladite commande de commutation externe (95) sur la base dudit temps d'ouverture et/ou temps de fermeture dudit dispositif disjoncteur (1).

15. Le contrôleur point sur onde (5) de l'une quelconque des revendications 13-14,
ledit contrôleur point sur onde (5) comprenant au moins une interface (8i) vers au moins un capteur (8) qui est conçu pour mesurer ledit paramètre supplémentaire.

16. Utilisation d'un contrôleur point sur onde (5) de l'une quelconque des revendications 13-15 dans un réseau de transmission de puissance (99).
